Europäisches Patentamt

European Patent Office

Office européen des brevets

(11) Numéro de publication : **0 352 155 B1**

(12) **FASCICULE DE BREVET EUROPEEN**

(19)

(45) Date de publication du fascicule du brevet :
**09.06.93 Bulletin 93/23**

(21) Numéro de dépôt : **89401835.7**

(22) Date de dépôt : **27.06.89**

(51) Int. Cl.$^5$ : **G01R 19/00**

(54) **Procédé de mesure d'un palier dans un signal bruité, et appareil de mesure automatique por la mise en oeuvre de ce procédé.**

(30) Priorité : **22.07.88 FR 8809936**

(43) Date de publication de la demande :
**24.01.90 Bulletin 90/04**

(45) Mention de la délivrance du brevet :
**09.06.93 Bulletin 93/23**

(84) Etats contractants désignés :
**AT DE ES GB IT NL**

(56) Documents cités :
**DE-C- 3 700 368**
**FR-A- 2 448 722**
**GB-A- 2 193 580**
**WIRELESS WORLD, vol. 87, no. 1544, mai 1981, pages 42-44, Sheepen Place, Colchester, GB; J.L. GORDON: "Data store by running avera-ge"**

(73) Titulaire : **THOMSON-LGT LABORATOIRE GENERAL DES TELECOMMUNICATIONS**
**1, rue de l'Hautil**
**F-78700 Conflans-Sainte Honorine (FR)**

(72) Inventeur : **Gauthier, Dominique**
**THOMSON-CSF SCPI Cédex 67**
**F-92045 Paris la Défense (FR)**

(74) Mandataire : **Lincot, Georges et al**
**THOMSON-CSF, SCPI, B.P. 329, 50, rue Jean-Pierre Timbaud**
**F-92402 Courbevoie Cédex (FR)**

Jouve, 18, rue Saint-Denis, 75001 PARIS

**Description**

L'invention concerne un procédé de mesure de l'amplitude d'un palier dans un signal bruité, et un dispositif de mesure pour mettre en oeuvre ce procédé.

Il est fréquent d'avoir à mesurer un palier dans un signal bruité. Par exemple, il s'agit de mesurer un palier dans un signal constitué d'une tension variable en fonction du temps, ou bien il s'agit de mesurer l'amplitude d'une raie dans un spectre variable en fonction du temps. Un procédé connu consiste à afficher le graphe du signal, avec le bruit, sur l'écran d'un tube cathodique et à interpréter visuellement le graphe de manière à ne pas tenir compte du bruit qui se traduit par une zone floue ayant une luminance décroissante de part et d'autre de la trace correspondant au signal utile. Cette interprétation visuelle réalise une sorte de filtrage qui ne prend en compte que la partie centrale de la trace diffuse apparaissant sur l'écran.

Cette méthode d'interprétation visuelle n'est évidemment pas applicable à un dispositif de mesure automatique. Dans ce cas, il est classique d'utiliser un filtre passe-bas éliminant les fréquences très supérieures à la fréquence fondamentale du signal commandant la déviation verticale dans le tube cathodique. Ce procédé a pour inconvénient son imprécision car la mesure est faussée par le résidu du bruit filtré qui s'ajoute au signal utile ; et est faussée éventuellement par une déformation non négligeable du signal utile. Le but de l'invention est de remédier à cet inconvénient de l'art antérieur.

L'objet de l'invention est un procédé numérique qui exploite le fait que la répartition statistique des échantillons d'un signal de bruit, notamment si c'est un bruit gaussien, est plus dense autour d'une valeur nulle.

Selon l'invention un procédé de mesure de l'amplitude d'un palier dans un signal bruité, est caractérisé en ce qu'il consiste à:
- échantillonner le signal pendant un intervalle de temps correspondant à la durée du palier à mesurer ;
- quantifier les échantillons du signal, selon une pluralité de valeurs numériques prédéterminés ;
- compter le nombre d'échantillons ayant chacune des valeurs numériques prédéterminées ;
- déterminer, dans une fourchette de valeurs fixée, quelle valeur correspond au plus grand nombre d'échantillons, cette valeur constituant la valeur mesurée de l'amplitude du palier.

L'invention sera mieux comprise et d'autres détails apparaîtront à l'aide de la description ci-dessus et des figures l'accompagnant :
- les figures 1 à 3 sont trois photos de l'écran d'un analyseur de spectres, illustrant les procédés de mesure connus ;
- la figure 4 représente un diagramme illustrant le procédé selon l'invention ;
- la figure 5 représente le schéma synoptique d'un exemple de réalisation du dispositif de mesure automatique pour la mise en oeuvre du procédé selon l'invention ;
- les figures 6 à 11 sont des photos de écran d'un analyseur de spectres utilisé dans cet exemple de réalisation, et illustrent la mise en oeuvre du procédé selon l'invention pour mesurer automatiquement l'amplitude d'une raie d'un spectre.

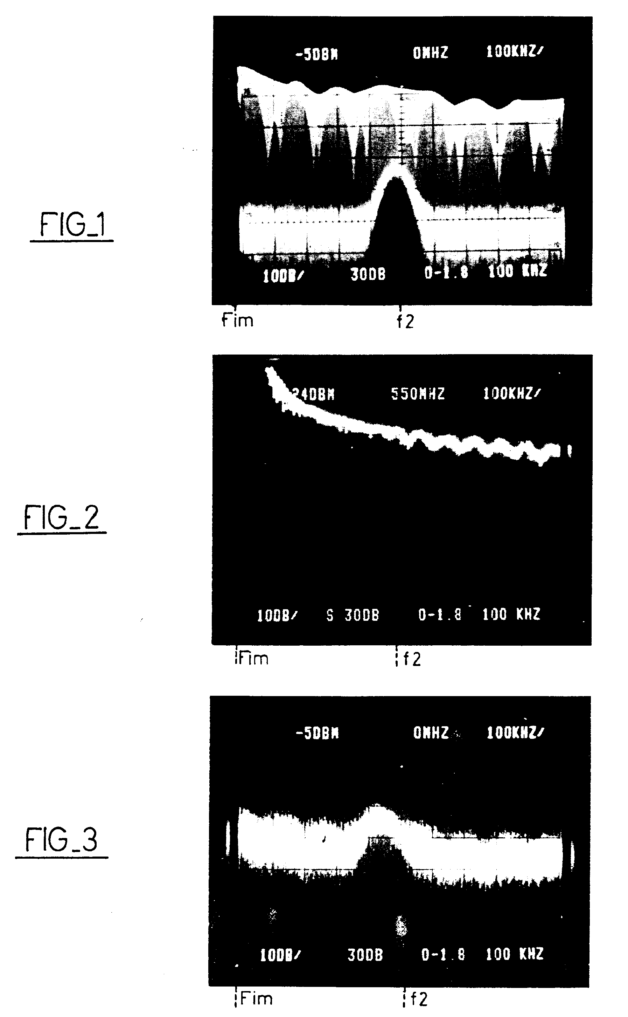

La figure 1 est la photo de l'écran d'un analyseur de spectres et illustre le cas où il est difficile de mesurer l'amplitude d'un palier dans un signal bruité. Le but de la mesure est de mesurer l'amplitude d'une raie créée par l'intermodulation d'une porteuse de chrominance et d'une porteuse d'image dans un signal de télévision qui traverse un amplificateur ou un émetteur comportant une voie commune pour l'image et pour le son. Sur cette photo, la raie d'intermodulation est située à une fréquence f2 pas très éloignée de la fréquence Fim de la porteuse image, qui correspond au bord gauche de la photo. La raie d'intermodulation apparaît comme un pic ayant un tracé diffus et, surtout, qui est surmonté de diverses raies qui sont dues à des fréquences multiples de la fréquence de ligne et qui apparaissent comme un bruit d'amplitude supérieure à l'amplitude de la raie d'intermodulation à mesurer.

Une interprétation visuelle de ce qui apparaît sur l'écran permet de distinguer la raie d'intermodulation par sa luminosité qui est un peu plus grande que celle du bruit superposé, mais qui est néanmoins assez diffuse. Lorsqu'il s'agit de réaliser une mesure automatique de amplitude de cette raie, on utilise classiquement un analyseur numérique de spectre, commandé par un contrôleur de bus IEEE, relié à l'analyseur par un bus transmettant à l'analyseur des signaux de commande remplaçant les réglages manuels et transmettant au contrôleur les données enregistrées par l'analyseur.

Il n'est pas possible d'obtenir une mesure automatique précise de l'amplitude de la raie d'intermodulation à la fréquence f2, directement à partir des données enregistrées correspondant à l'image de la figure 1, à cause du bruit superposé. Ces données sont constituées par les valeurs numériques d'une suite d'échantillons, chaque échantillon de spectre correspondant à un point lumineux sur l'écran. La largeur de l'écran correspond, par exemple, à 1000 échantillons. Les données correspondant à chaque échantillon sont constituées par son abscisse sur l'axe horizontal de l'écran et par son ordonnée, sur un axe vertical de l'écran, cette ordonnée pouvant prendre une valeur entière comprise entre 0 et 255. Sur l'écran, les zones ayant une plus forte luminosité sont celles où les échantillons sont les plus rapprochés les uns des autres.

Classiquement, un analyseur numérique de spectre comporte un ou plusieurs filtres commutables agissant sur le signal commandant la déviation verticale dans le tube cathodique, et permettant d'éliminer au moins en partie le bruit gênant l'observation du spectre sur l'écran. La figure 2 est une photo de l'écran de l'analyseur représentant le même spectre que la photo de la figure 1, mais en mettant en service un premier type de filtre qui ne laisse passer que l'enveloppe du signal commandant la déviation verticale. Le spectre affiché sur l'écran est en fait l'enveloppe de la zone nébuleuse que constituent les raies dues aux fréquences multiples de la fréquence ligne. La raie d'intermodulation à la fréquence f2 disparaît complètement. Il n'est donc pas possible d'utiliser ce premier type de filtre pour réaliser, visuellement ou automatiquement, une mesure de la raie d'intermodulation considérée.

Classiquement, un analyseur de spectres comporte aussi un filtre moyenneur commutable qui réalise un filtrage passe-bas sur le signal commandant la déviation verticale. La figure 3 est une photo de l'affichage obtenue sur l'écran, pour le même spectre que celui de la figure 1, et avec les mêmes réglages de l'analyseur, mais en mettant en service le filtre moyenneur. Il apparaît que ce filtrage a supprimé la zone nébuleuse due aux raies des fréquences multiples de la fréquence ligne. Il est possible de mesurer visuellement ou automatiquement, un palier horizontal au voisinage de la fréquence f2 où est située la raie d'intermodulation attendue. Cependant il apparaît que la valeur mesurée est erronée par rapport à la valeur mesurée sur la photo de la figure 1. L'erreur, qui est ici de l'ordre de 10 dB, est d'autant plus grande que le niveau de bruit est supérieur au niveau du palier à mesurer. Cette erreur est due au fait que le filtre moyenneur inclut des échantillons fortement bruités dans le calcul de la valeur du signal moyen destiné à commander l'affichage. Ce type de filtrage n'est donc pas utilisable lorsqu'il est nécessaire de réaliser une mesure automatique avec une bonne précision, c'est-à-dire de l'ordre de 0,5 ou 0,2 dB.

Le procédé de mesure selon l'invention exploite la connaissance a priori de l'existence d'un palier pendant un intervalle de temps connu, dans le signal considéré. il exploite aussi le fait que le bruit affectant le signal est en général un bruit gaussien, ou tout au moins un bruit dont les valeurs ont une répartition statistique fortement concentrée autour de la valeur zéro. Les échantillons qui ont une valeur égale ou proche de la valeur réelle du palier en l'absence de bruit sont donc plus nombreux que les échantillons ayant une valeur sensiblement différente de la valeur de ce palier. Cette différence de répartitions permet de situer le niveau du palier. Les échantillons dont la valeur n'est pas considérée comme proche sont alors considérés comme étant trop bruités et ne sont pas du tout pris en compte. Le procédé réalise donc un filtrage dans lequel les échantillons considérés comme proches du palier sont pondérés par un coefficient égal à 1 alors que les échantillons dont la valeur n'est pas considérée comme proche du palier sont pondérés avec un coefficient égal à zéro, alors que le procédé de filtrage passe-bas classique réalise une moyenne dans laquelle tous les échantillons, même complètement aberrants, ont un poids égal.

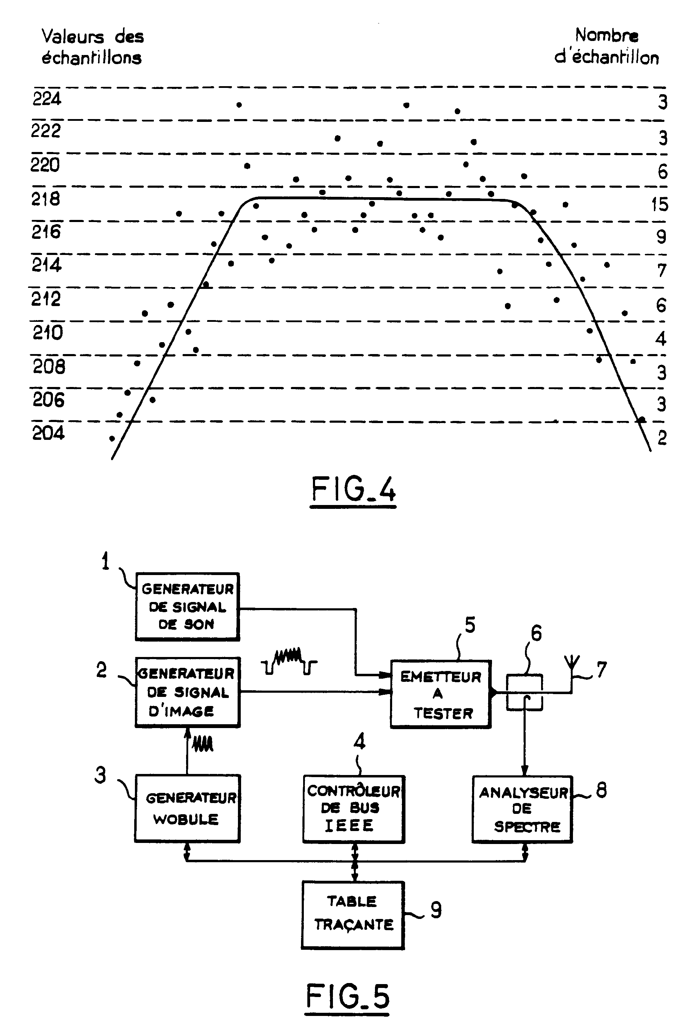

La figure 4 représente un diagramme illustrant un exemple de mise en oeuvre du procédé selon l'invention. Sur cette figure, chaque point noir représente un échantillon d'un signal bruité qui est le signal appliqué au dispositif d'affichage d'un analyseur de spectre. Dans cet exemple, le signal représente une raie ayant une forme trapézoïdale, comportant un palier horizontal au centre de l'écran d'affichage. La courbe en trait noir représente la raie telle qu'elle serait vue en l'absence de bruit, alors que le spectre observé réellement est constitué par les points noirs qui sont, en réalité, reliés par la trace lumineuse du spot sur l'écran d'affichage. Cette trace reliant les échantillons n'est pas représentée pour plus de clarté. Dans cet exemple, les échantillons peuvent prendre des valeurs entières entre 0 et 255. L'échelle des valeurs des échantillons est représentée sur la gauche de la figure. La mesure de la valeur du palier consiste à découper cette échelle 0-255 en tranches de deux unités chacune ; puis à compter le nombre d'échantillons ayant une valeur comprise dans chaque tranche. Par exemple, les échantillons ayant une valeur égale à 209 ou à 210 sont au nombre de quatre. Le nombre d'échantillons appartenant à chaque tranche est représenté sur la droite de la figure.

Puis le procédé consiste à déterminer dans quelle tranche le nombre d'échantillons est le plus grand. Dans cet exemple, c'est la tranche des échantillons de valeur 217 ou 218, qui contient 15 échantillons. Les deux tranches voisines contiennent respectivement 6 et 9 échantillons. Le palier est considéré comme situé dans la tranche des valeurs 217 et 218. Sa valeur en décibels, par rapport à une référence, peut alors être calculée à partir des paramètres de réglage de l'analyseur.

La figure 5 représente le schéma synoptique d'un exemple de réalisation d'un banc de mesure automatique pour réaliser des mesures d'intermodulation sur un émetteur de télévision comportant une voie commune pour l'image et le son, en mettant en oeuvre le procédé de mesure selon l'invention. Ce banc de mesure automatique comporte : un générateur de signal son, 1 ; un générateur de signal d'image, 2 ; un générateur vobulé, 3, fournissant une porteuse de chrominance ; un contrôleur de bus, IEEE, 4 ; un émetteur TV à tester, 5 ; une sonde de mesure, 6 ; une antenne 7 pour charger la sortie de l'émetteur 5 ; un analyseur numérique de spectre, 8 ; et une table traçante, 9, pour tracer automatiquement le graphe de l'amplitude de la raie d'intermodulation mesurée, en fonction de la valeur de la fréquence de la porteuse de chrominance, celle-ci étant vobulée sur toute la gamme de la bande vidéo entre porteuse image et porteuse son.

L'émetteur 5 possède : une première entrée reliée à une sortie du générateur 1 de signal de son, qui lui fournit une porteuse modulée par un signal audio ; une deuxième entrée reliée à une sortie du générateur 2 de signal d'image, qui lui fournit une porteuse d'image modulée par un signal de chrominance dont la porteuse de chrominance est vobulée ; et une sortie reliée à l'antenne 7 par l'intermédiaire de la sonde de mesure 6. Le générateur 2 possède une entrée reliée à une sortie du générateur vobulé 3 qui lui fournit une porteuse de chrominance vobulée.

Le générateur 3, le contrôleur 4, l'analyseur 8, et la table traçante 9 possèdent chacun une entrée-sortie reliée à un bus IEEE. Le contrôleur 4 commande le générateur 3, pour faire varier la fréquence de chrominance ; commande l'analyseur 8 pour mesurer l'amplitude de la raie d'intermodulation dans le spectre du signal fourni par la sortie de l'émetteur 5 ; et commande la table traçante 9 pour tracer le graphe des résultats de mesure. Le générateur 3, le contrôleur 4, l'analyseur 8, et la table traçante 9, sont des appareils de mesure classiques commandables par un bus IEEE. Le contrôleur 4 est un dispositif classique à microprocesseur réalisant une séquence de commande du banc de mesure, puis une séquence de calculs, selon un programme préalablement chargé dans ce contrôleur. Le contrôleur 4 met en oeuvre le procédé selon l'invention en l'appliquant aux valeurs d'échantillons lues dans la mémoire d'écran de l'analyseur 8.

Le contrôleur 4 commande le banc de mesure pour réaliser une suite de mesures correspondant à une suite de valeurs Fch de la fréquence de chrominance. Lorsque le générateur 1 fournit un signal de son ayant une fréquence porteuse Fson et lorsque le générateur 2 fournit un signal d'image ayant une fréquence porteuse Fim, avec un signal de chrominance ayant une fréquence porteuse Fch, l'émetteur à tester restitue un signal qui comporte deux raies principales d'intermodulation ayant pour fréquence :

$$f1 = Fim - Fson + Fch$$
$$f2 = Fim + Fson - Fch$$

Les deux raies sont d'amplitudes égales. Seule la raie de fréquence f2, par exemple, est mesurée. Le contrôleur 4 calcule f2 pour chaque valeur Fch donnée, conformément à la formule précédente, puis commande la séquence des opérations nécessaires pour faire une mesure à cette fréquence f2.

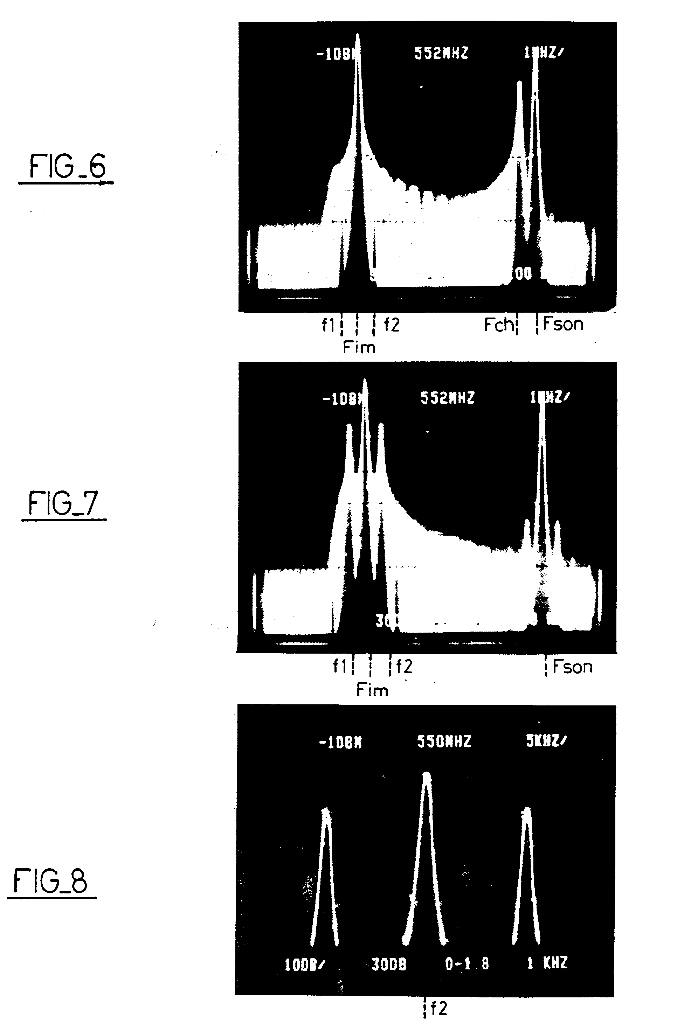

La figure 6 est une photo du spectre affiché sur l'écran de l'analyseur de spectres lorsqu'il est réglé pour visualiser l'ensemble du spectre du signal fourni par la sortie de l'émetteur 5. Dans cet exemple le signal de télévision est aux normes allemandes B/G. La porteuse du signal de son, de fréquence Fson, est située à 5,5 MHz de la fréquence Fim de la porteuse d'image. Dans l'exemple représenté, la fréquence Fch de la porteuse de chrominance est située à 5 MHz de la fréquence porteuse d'image Fim, du même côté que la fréquence porteuse du signal son. Conformément aux formules précédentes, l'intermodulation produit deux raies qui sont situées à 0,5 MHz de part et d'autre de la fréquence porteuse d'image Fim.

La référence des mesures est constituée par l'amplitude de la porteuse d'image. Pour la norme considérée, la porteuse du signal de son a une amplitude de -10 dB et la porteuse de chrominance a une amplitude de -16 dB. Dans ces conditions l'amplitude des deux raies d'intermodulation a une valeur qui est comprise généralement dans la gamme de -48 à -75 dB. Cette valeur est très inférieure à l'amplitude du spectre nébuleux créé par les fréquences multiples de la fréquence de ligne. C'est pourquoi il est difficile de distinguer sur l'écran d'affichage, et sur la photo, l'amplitude des raies d'intermodulation. Pour mieux distinguer ces raies, il est nécessaire de dilater la zone du spectre où est située l'une de ces raies, en la centrant au centre de l'écran de l'analyseur.

La mesure d'intermodulation sur un émetteur TV est réalisée pour toute une suite de valeurs de la fréquence Fch du signal de chrominance, de telle façon que les raies d'intermodulation se déplacent sur tout l'intervalle entre Fson et Fim. Chaque mesure d'une raie d'intermodulation à une fréquence f2 prédéterminée donne lieu à une suite d'opérations décrites ci-dessous. Ces opérations sont programmées dans le contrôleur 4 et sont réalisées automatiquement, puis le contrôleur 4 modifie la fréquence porteuse de chrominance, par pas de valeur fixée, avant de réaliser la prochaine mesure.

Une première étape du procédé selon l'invention consiste à échantillonner le signal bruité pendant l'intervalle de temps le plus intéressant, c'est-à-dire pendant la durée du palier à mesurer. En pratique, cela consiste à régler l'analyseur pour centrer la fenêtre d'observation exactement sur la fréquence f2 où est attendue une raie d'intermodulation pour une fréquence de chrominance donnée. Cette fréquence f2 est connue a priori, mais malheureusement l'imprécision d'un centrage réalisé directement sur la fréquence f2 est souvent insuffisante.

Pour centrer exactement la fenêtre d'observation, un procédé consiste à commander l'analyseur pour chercher automatiquement la raie d'amplitude maximale dans une fenêtre d'observation donnée, puis centrer la fenêtre d'observation sur la raie ainsi détectée. Malheureusement cette opération automatique ne prend en compte que l'enveloppe du spectre et par conséquent ne peut pas détecter le sommet des raies d'intermodulation lorsqu'elles sont d'amplitude inférieure au bruit constitué par le spectre des fréquences multiples de la fréquence ligne. Un remède consiste à simuler la raie d'intermodulation en injectant à la fréquence f2 une porteuse d'amplitude supérieure au bruit. Ceci peut être fait simplement en donnant la valeur f2 à fréquence de la porteuse de chrominance, en lui conservant l'amplitude de -16 dB. Après l'opération de ce centrage, la fréquence de la porteuse de chrominance prendra la valeur Fch nécessaire pour la mesure proprement dite.

La figure 7 est une photo du spectre affiché sur l'écran de l'analyseur lorsque la porteuse de chrominance a la fréquence f2 pour simuler la raie d'intermodulation. Ce spectre comporte deux raies d'amplitude supérieure au bruit, situées respectivement aux fréquences f1 et f2 de part et d'autre de la fréquence porteuse d'image. Il est à remarquer aussi que l'intermodulation provoque l'apparition de deux raies situées de part et d'autre de la fréquence porteuse du signal de son. L'opération de centrage peut alors être réalisée avec précision sur la fréquence f2 puisque la raie en f2 a une amplitude supérieure à celle du bruit. L'analyseur est commandé pour centrer sa fenêtre d'observation sur le sommet de la raie existant à la fréquence f2.

La figure 8 est une photo représentant le spectre observé après cette opération de centrage. Le spectre observé comporte trois raies. La raie centrale, qui est la plus grande, est située à la fréquence f2. Les deux autres raies sont des raies produites par des fréquences multiples de la fréquence de ligne.

Pour réaliser une mesure d'amplitude précise, il est nécessaire de faire apparaître très large le palier constituant le sommet de la raie, en dilatant le plus possible le spectre observé. Cette dilatation dilate aussi l'erreur de centrage, par conséquent il est nécessaire de supprimer cette erreur de centrage, en effectuant un nouveau centrage avant de passer à l'étape de la mesure de l'amplitude réelle de la raie d'intermodulation. Le procédé consiste à commander un premier changement d'échelle horizontale, puis à commander une première recherche de la raie d'amplitude maximale dans la fenêtre d'observation, puis à commander un premier centrage de cette raie au centre de la fenêtre d'observation. Puis à commander un deuxième changement de l'échelle horizontale, puis à commander une deuxième recherche de la raie d'amplitude maximale, puis à commander un deuxième centrage de cette raie. Ces opérations sont réitérées jusqu'à ce que l'échelle horizontale ait été dilatée au maximum possible sur l'analyseur utilisé. L'analyseur est alors prêt pour permettre la mesure réelle de l'amplitude de la raie d'intermodulation dans les meilleures conditions.

Le procédé consiste alors à commander le générateur 3 pour qu'il fournisse une porteuse de chrominance ayant la fréquence Fch correspondant à la fréquence f2 sur laquelle le centrage vient d'être fait. Les valeurs mesurées sont attendues dans la gamme -48 dB à -75 dB par rapport à l'amplitude de la porteuse du signal d'image. L'analyseur est donc commandé pour que son échelle verticale soit centrée sur cette gamme de valeurs.

La deuxième étape du procédé de mesure selon l'invention, est analogue à celle décrite pour l'exemple représenté sur la figure 4. L'amplitude calculée est transmise à la table traçante, avec la valeur f2, pour inscrire un point du graphe de mesure, puis les opérations précédentes sont réitérées pour une nouvelle valeur de f2.

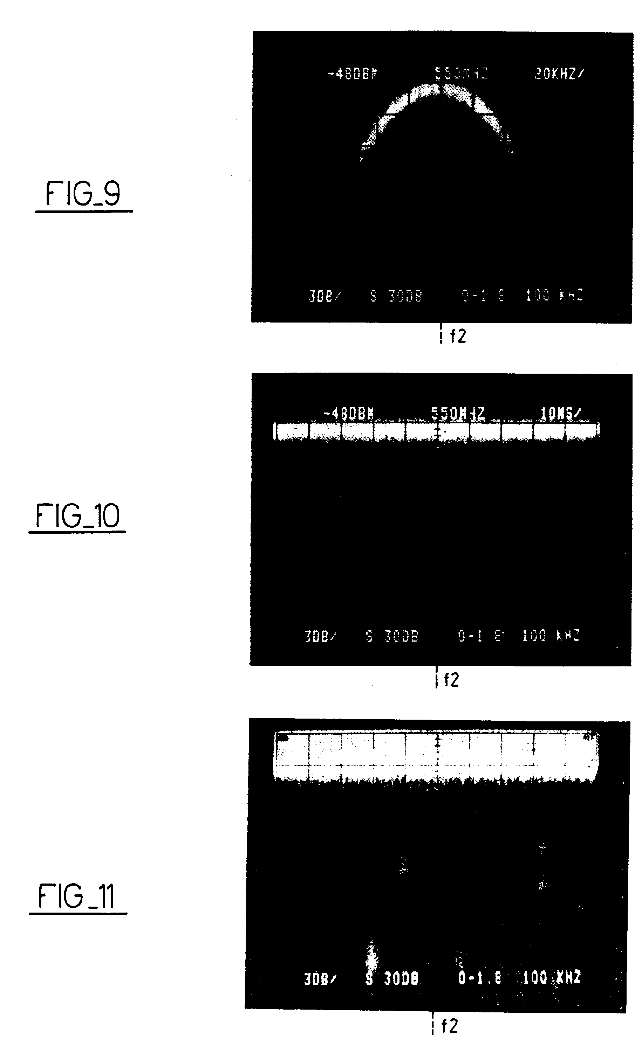

La figure 9 est une photo de la raie d'intermodulation à la fréquence f2, affichée directement sur l'écran de manière analogique au cours des opérations de centrage décrites ci-dessus. La raie est parfaitement centrée dans la fenêtre d'observation. La figure 10 est la photo de l'écran représentant la même raie, de manière analogique, après dilatation maximale de l'échelle horizontale. La figure 11 représente le même spectre que celui de la figure 10, mais en passant par le traitement numérique de l'analyseur, et avec les mêmes réglages de celui-ci. Cette image correspond donc aux données qui sont utilisées pour déterminer automatiquement le niveau du palier.

Cet exemple de mise en oeuvre comporte deux opérations supplémentaires permettant d'améliorer la fiabilité de la mesure. Une première opération consiste à comparer la valeur de chaque échantillon à une borne maximale fixée, dans cet exemple 225, pour éliminer toutes les valeurs qui sont tellement grandes qu'elles n'appartiennent certainement pas au palier. Cette opération élimine notamment un grand nombre d'échantillons ayant pour valeurs 255 après dilatation de l'échelle verticale, car les valeurs plafonnent alors à 255.

Une seconde opération consiste à ne valider la mesure d'un palier qu'après avoir confirmé son existence, en calculant la valeur moyenne des échantillons pris en compte après la première opération décrite ci-dessus, et en comparant cette valeur moyenne à deux bornes, fixées par exemple à -48 dB et à -75 dB. Si la valeur moyenne est effectivement comprise entre ces bornes cela confirme l'existence du palier attendu entre ces deux bornes. Dans le cas contraire, quelle que soit la valeur mesurée, l'existence d'un palier mesurable est douteuse.

Le cas considéré précédemment est le cas où la mesure de la raie d'intermodulation est la plus délicate parce que cette raie est proche de la fréquence porteuse du signal d'image, donc dans une zone où le niveau de bruit créé par les fréquences multiples de la fréquence ligne est particulièrement important. Naturellement, le procédé selon l'invention peut être mis en oeuvre de la même façon pour mesurer la raie d'intermodulation lorsque, la fréquence de chrominance ayant été modifiée, cette raie d'intermodulation est située à proximité de la fréquence porteuse du signal de son. Elle est alors de niveau comparable au niveau du spectre du bruit et la mesure de l'amplitude de cette raie est donc facilitée.

Le procédé selon l'invention est applicable non seulement aux analyseurs numériques de spectres mais à tout autre dispositif numérique de mesure, lorsque il est nécessaire de remplacer l'interprétation visuelle par un procédé de mesure automatique, pour mesurer un palier dont la position temporelle est connue a priori. Notamment, ce procédé de mesure peut être appliqué à un banc de mesure automatique comportant un oscilloscope numérique au lieu d'un analyseur numérique de spectre.

## Revendications

1. Procédé de mesure de l'amplitude d'un palier dans un signal bruité, caractérisé en ce qu'il consiste à :
   - échantillonner le signal pendant un intervalle de temps correspondant à la durée du palier à mesurer ;
   - quantifier les échantillons du signal, selon une pluralité de valeurs numériques prédéterminés ;
   - compter le nombre d'échantillons ayant chacune des valeurs numériques prédéterminées ;
   - déterminer, dans une fourchette de valeurs fixée, quelle valeur correspond au plus grand nombre d'échantillons, cette valeur constituant la valeur mesurée de l'amplitude du palier.

2. Procédé selon la revendication 1, caractérisé en ce qu'il consiste en outre à ne pas compter les échantillons ayant des valeurs supérieures à une borne maximale fixée.

3. Procédé selon la revendication 2, caractérisé en ce que, pour vérifier l'existence d'un palier dans le signal bruité au cours de l'intervalle de temps où il est échantillonné, il consiste en outre à calculer la valeur moyenne arithmétique des valeurs des échantillons ayant une valeur inférieure à la borne maximale ; et à vérifier que cette valeur moyenne est comprise dans un intervalle de valeurs où la valeur du palier est située vraisemblablement.

4. Dispositif de mesure, pour la mise en oeuvre du procédé selon la revendication 1, en vue de mesurer l'amplitude d'un palier dans un signal bruité, caractérisé en ce qu'il comporte :
   - des moyens (8) pour échantillonner le signal pendant un intervalle de temps fixé, correspondant à la durée du palier ;
   - des moyens (8) pour quantifier les échantillons du signal selon une pluralité de valeurs numériques prédéterminées ;

   - des moyens (4) pour compter le nombre d'échantillons ayant respectivement chacune des valeurs numériques prédéterminées, et pour déterminer la valeur correspondant au plus grand nombre d'échantillons, cette valeur constituant la mesure de l'amplitude du palier du signal bruité.

5. Dispositif selon la revendication 4, caractérisé en ce que les moyens (4) pour compter le nombre d'échantillons ayant chacune des valeurs prédéterminées et pour déterminer la valeur correspondant au plus grand nombre d'échantillons, ne prennent pas en compte les échantillons ayant une valeur supérieure à une borne fixée.

6. Dispositif selon la revendication 5, caractérisé en ce qu'il comporte en outre des moyens (4) pour : calculer la valeur moyenne de tous les échantillons pris en compte : comparer cette valeur moyenne à deux bornes : et valider la mesure du palier seulement dans le cas où la valeur moyenne est comprise entre les deux bornes.

## Patentansprüche

1. Verfahren zum Messen der Amplitude einer Stufe in einem Rauschsignal, dadurch gekennzeichnet, daß es darin besteht, daß:
   - das Signal während eines der Dauer der zu messenden Stufe entsprechenden Zeitintervalls abgetastet wird;
   - daß die Abtastwerte des Signals gemäß mehreren vorbestimmten digitalen Werten quantifiziert werden;
   - daß die Anzahl der Abtastwerte gezählt wird, die jeweils vorbestimmte digitale Werte haben;
   - daß in einem Bereich fester Werte bestimmt wird, welcher Wert der größten Anzahl von Abtastwerten entspricht, wobei dieser Wert den Meßwert der Amplitude der Stufe bildet.

2. Verfahren nach Anspruch 1, dadurch gekennzeichnet, daß es ferner darin besteht, daß die Abtastwerte nicht gezählt werden, deren Werte größer als ein fester Maximalwert sind.

3. Verfahren nach Anspruch 2, dadurch gekennzeichnet, daß es zum Verifizieren der Anwesenheit einer Stufe in dem Rauschsignal im Verlauf des Zeitintervalls, in dem es abgetastet wird, ferner darin besteht, daß der arithmetische Mittelwert der Abtastwerte berechnet wird, die einen unter dem maximalen Grenzwert liegenden Wert haben, und daß verifiziert wird, ob dieser Mittelwert in einem Intervall von Werten liegt, in dem der Wert der Stufe wahrscheinlich liegt.

4. Meßvorrichtung zur Durchführung des Verfahrens nach Anspruch 1 zum Messen der Amplitude einer Stufe in einem Rauschsignal, dadurch gekennzeichnet, daß sie enthält:
   - Mittel (8) zum Abtasten des Signals während eines festen Zeitintervalls entsprechend der Dauer der Stufe,
   - Mittel (8) zum Quantifizieren der Abtastwerte des Signals entsprechend mehreren vorbestimmten digitalen Werten;
   - Mittel (4) zum Zählen der Anzahl der Abtastwerte, die jeweils vorbestimmte digitale Werte haben, und zum Bestimmen des Werts, der der größten Anzahl von Abtastwerten entspricht, wobei dieser Wert den Amplitudenmeßwert der Stufe des Rauschsignals bildet.

5. Vorrichtung nach Anspruch 4, dadurch gekennzeichnet, daß die Mittel (4) zum Zählen der Anzahl der Abtastwerte, die jeweils vorbestimmte Werte haben, und zum Bestimmen des Werts, der der größten Anzahl von Abtastwerten entspricht, die Abtastwerte nicht berücksichtigen, die einen Wert haben, der größer als ein fester Grenzwert ist.

6. Vorrichtung nach Anspruch 5, dadurch gekennzeichnet, daß sie ferner Mittel (4) enthält zum: Berechnen des Mittelwerts aller berücksichtigten Abtastwerte; Vergleichen dieses Mittelwerts mit zwei Grenzwerten; Bestätigen der Messung der Stufe nur für den Fall, daß der Mittelwert zwischen den zwei Grenzwerten liegt.

**Claims**

1. Method of measuring the amplitude of a plateau in a noisy signal, characterised in that it consists in:
   - sampling the signal during a time interval corresponding to the duration of the plateau to be measured;
   - quantifying the samples of the signal, according to a plurality of predetermined numerical values;
   - counting the number of samples each having predetermined numerical values;
   - determining, in a bracket of fixed values, which value corresponds to the greatest number of samples, this value constituting the measured value of the amplitude of the plateau.

2. Method according to Claim 1, characterised in that it further consists in not counting the samples having values greater than a fixed maximum bound.

3. Method according to Claim 2, characterised in that, in order to verify the existence of a plateau in the noisy signal in the course of the time interval in which it is sampled, it further consists in calculating the arithmetic mean value of the values of the samples having a value less than the maximum bound; and in verifying that this mean value lies in an interval of values in which the value of the plateau is probably situated.

4. Measuring device, for implementing the method according to Claim 1, with a view to measuring the amplitude of a plateau in a noisy signal, characterised in that it includes:
   - means (8) for sampling the signal during a fixed time interval, corresponding to the duration of the plateau;
   - means (8) for quantifying the samples of the signal according to a plurality of predetermined numerical values;
   - means (4) for counting the number of samples respectively having each of the predetermined numerical values, and for determining the value corresponding to the greatest number of samples, this value constituting the measurement of the amplitude of the plateau of the noisy signal.

5. Device according to Claim 4, characterised in that the means (4) for counting the number of samples having each of the predetermined values and for determining the value corresponding to the greatest number of samples, do not take into account the samples having a value greater than a fixed bound.

6. Device according to Claim 5, characterised in that it further comprises means (4) for: calculating the mean value of all the samples taken into account; comparing this mean value to two bounds; and validating the measurement of the plateau only in the event that the mean value lies between the two bounds.

FIG_1

FIG_2

FIG_3

Valeurs des
échantillons

Nombre
d'échantillon

| | |
|---|---|
| 224 | 3 |
| 222 | 3 |
| 220 | 6 |
| 218 | 15 |
| 216 | 9 |
| 214 | 7 |
| 212 | 6 |
| 210 | 4 |
| 208 | 3 |
| 206 | 3 |
| 204 | 2 |

## FIG.4

1 GENERATEUR
DE SIGNAL
DE SON

2 GENERATEUR
DE SIGNAL
D'IMAGE

3 GENERATEUR
WOBULE

4 CONTRÔLEUR
DE BUS
IEEE

5 EMETTEUR
A
TESTER

6

7

8 ANALYSEUR
DE
SPECTRE

9 TABLE
TRAÇANTE

## FIG.5

FIG_6

FIG_7

FIG_8

FIG_9

FIG_10

FIG_11